# EUROPEAN PATENT APPLICATION

(11) **EP 3 751 023 A1**
(43) Date of publication of application: **16.12.2020**
(21) Application number: 19750633.0
(22) Date of filing: 06.02.2019
(51) Int. Cl.: C30B 29/38, C30B 25/18, H01L 21/20, H01L 21/205, H01L 21/338, H01L 29/778, H01L 29/812

(54) **SEMICONDUCTOR WAFER**

(30) Priority: 08.02.2018 JP 2018020954
(71) Applicant: SUMITOMO CHEMICAL COMPANY LIMITED, Chuo-ku Tokyo 104-8260 (JP)
(72) Inventor: YAMAMOTO, Taiki, Hitachi-shi, Ibaraki 319-1418 (JP); IKEJIRI, Keitaro, Hitachi-shi, Ibaraki 319-1418 (JP)
(74) Representative: Vossius & Partner Patentanwälte Rechtsanwälte mbB
(86) International application number: PCT/JP2019/004252
(87) International publication number: WO 2019/156121

(57) **Abstract**

One embodiment of the present invention provides a semiconductor wafer **1** which is provided with: a substrate **10** that is mainly composed of Si, a buffer layer **11** that is formed on the substrate **10** and comprises an AlN layer **11**a as the lowermost layer; and a nitride semiconductor layer **12** that is formed on the buffer layer **11** and contains Ga. This semiconductor wafer **1** is configured such that the pit density of the upper surface of the AlN layer **11**a is more than **0** but less than **2.4** × **10¹⁰** cm⁻².

## Description

### [Technical Field]

The present invention relates to a semiconductor wafer.

### [Background Art]

Conventionally, there is known a technique for enhancing the quality of a nitride semiconductor layer formed over a Si (silicon) substrate by epitaxial crystal growth (see, e.g., Patent Document 1).

The technique as disclosed in Patent Document **1** is designed to form an AlN (aluminium nitride) based thin film, which serves as a buffer layer to be formed over a surface of a substrate including a Si substrate, in a plurality of stages each with a different condition for film formation, and thereby lessen the occurrence of a crack formation or a pit formation in a group III nitride thin film layer to be formed over the AlN based thin film.

### [Prior Art Document]

### [Patent Document]

Patent Document **1:** JP-A-2007-59850

### [Summary of Invention]

### [Technical Problem]

However, not every one of the nitride semiconductor layers formed over the Si substrate is enhanced in the quality, even by using the technique as disclosed in Patent Document 1. For that reason, requiring the nitride semiconductor layers formed over the Si substrate to be high in the quality leads to an increase in the number of defective units not meeting the quality criteria, and a lowering in the production yield.

An object of the present invention is to provide a semiconductor wafer, which is designed to include therein a nitride semiconductor layer over a Si substrate, and which has a structure designed to have a sufficient breakdown voltage for a specific use and be able to be produced at a high production yield.

### [Means for Solving the Technical Problem]

For the purpose of achieving the above object, one aspect of the present invention provides a semiconductor wafer as defined in [**1**] to [**3**] below.
[**1**] A semiconductor wafer, comprising: a substrate mainly composed of Si; a buffer layer formed over the substrate and comprises an AlN layer as a lowermost layer; and a nitride semiconductor layer formed over the buffer layer and includes Ga, wherein the semiconductor wafer is configured in such a manner that a pit density of an upper surface of the AlN layer is more than **0** but less than **2.4** × **10¹⁰** cm⁻².
[**2**] The semiconductor wafer as defined in the above [**1**], wherein the pit density of the upper surface of the AlN layer is not more than **5.5** × **10⁹** cm⁻².
[**3**] The semiconductor wafer as defined in the above [**2**], wherein the pit density of the upper surface of the AlN layer is not more than **1.4** × **10⁹** cm⁻².

### [Effect of the Invention]

According to the present invention, it is possible to provide the semiconductor wafer, which is designed to include therein the nitride semiconductor layers over the Si substrate, and which has a structure designed to have a sufficient breakdown voltage for a specific use and be able to be produced at a high production yield.

### [Brief Description of Drawings]

**FIG. 1** is a vertical cross-sectional view showing a semiconductor wafer according to an embodiment.
**FIG. 2**A is a vertical cross-sectional view showing a step of producing the semiconductor wafer according to the embodiment.

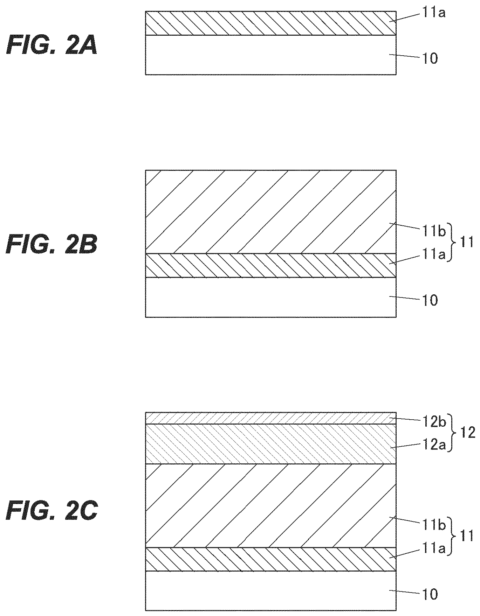

**FIG. 2**B is a vertical cross-sectional view showing a step of producing the semiconductor wafer according to the embodiment.
**FIG. 2**C is a vertical cross-sectional view showing a step of producing the semiconductor wafer according to the embodiment.

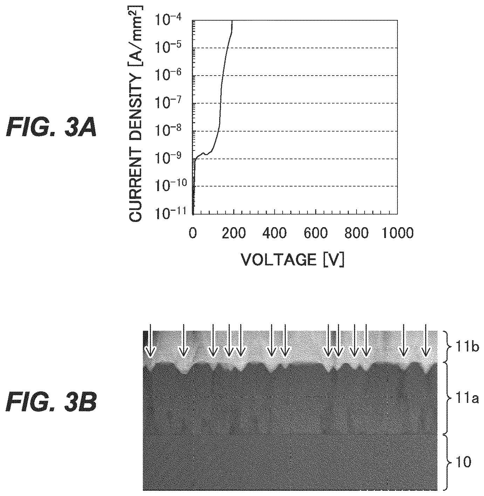

**FIG. 3**A is a graph showing a current-voltage characteristic of a specimen A according to an example.
**FIG. 3**B is a TEM image showing a cross section in a perpendicular direction of the specimen A according to the example.

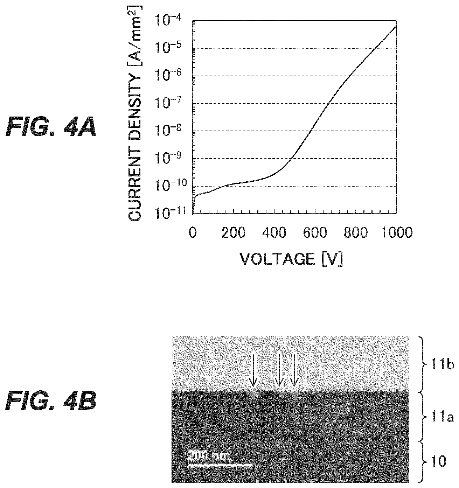

**FIG. 4**A is a graph showing a current-voltage characteristic of a specimen B according to the example.
**FIG. 4**B is a TEM image showing a cross section in a perpendicular direction of the specimen B according to the example.

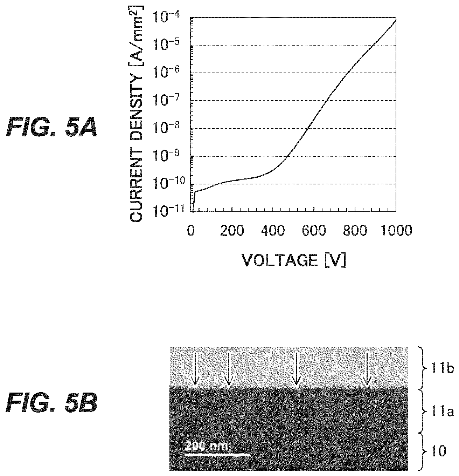

**FIG. 5**A is a graph showing a current-voltage characteristic of a specimen C according to the example.
**FIG. 5**B is a TEM image showing a cross section in the perpendicular direction of the specimen C according to the example.

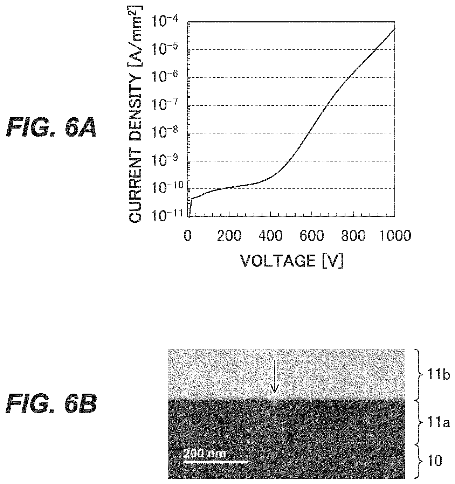

**FIG. 6**A is a graph showing a current-voltage characteristic of a specimen D according to the example.
**FIG. 6**B is a TEM image showing a cross section in the perpendicular direction of the specimen D according to the example.

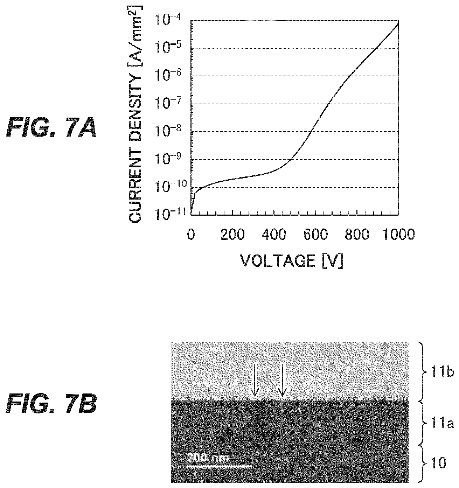

**FIG. 7**A is a graph showing a current-voltage characteristic of a specimen E according to the example.
**FIG. 7**B is a TEM image showing a cross section in the perpendicular direction of the specimen E according to the example.

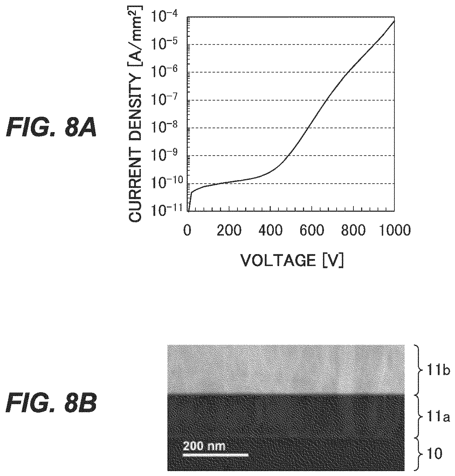

**FIG. 8**A is a graph showing a current-voltage characteristic of a specimen F according to the example.
**FIG. 8**B is a TEM image showing a cross section in the perpendicular direction of the specimen F according to the example.

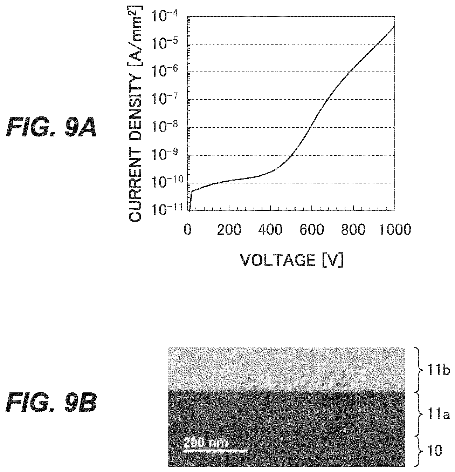

**FIG. 9**A is a graph showing a current-voltage characteristic of a specimen G according to the example.
**FIG. 9**B is a TEM image showing a cross section in the perpendicular direction of the specimen G according to the example.

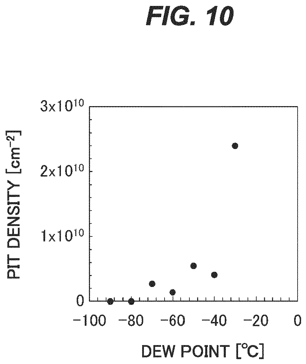

**FIG. 10** is a graph showing relationships between dew points during forming AlN layers and pit densities of upper surfaces of those AlN layers, obtained from the results of measuring the specimens A to G according to the Examples.

### [Description of Embodiment]

### (Configuration of a semiconductor wafer 1)

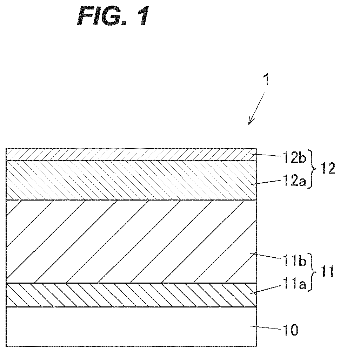

**FIG. 1** is a vertical cross-sectional view showing a semiconductor wafer **1** according to an embodiment. The semiconductor wafer **1** is configured to include therein a substrate **10,** which is mainly composed of Si, a buffer layer **11,** which is formed over the substrate **10,** and a nitride semiconductor layer **12,** which is formed over the buffer layer **11** and which is configured in such a manner as to include Ga (gallium) therein. The buffer layer **11** formed over the substrate **10** is configured to include therein an AlN layer **11**a, and an upper layer **11**b, which is formed over the AlN layer **11**a.

The substrate **10** is a substrate mainly composed of Si, and is typically a Si substrate. For the Si substrate **10,** the Si substrate of a large diameter can be prepared at a low cost.

The AlN layer **11**a is a film including no Ga therein and coat a surface of the substrate **10,** and prevents the occurrence of a reaction between the Si included in the substrate **10** and the Ga included in the layers to be formed above the substrate **10.**

The AlN layer **11**a may have a two-layer structure composed of a low temperature grown layer, which is formed at a low growth temperature (e.g., **1000** to **1150** degrees C), and a high temperature grown layer, which is formed over the low temperature grown layer at a high growth temperature (e.g., **1100** to **1300** degrees C). The higher the growing temperature for the AlN layer **11**a, the higher the crystal quality of the AlN layer **11**a becomes, and the larger the strain of the AlN layer **11**a due to the lattice mismatch between the AlN layer **11**a and the substrate **10** becomes. Further, as the strain of the AlN layer **11**a becomes larger, the upper surface of the AlN layer **11**a is more liable to a pit formation.

For this reason, by configuring the lower layer of the AlN layer **11**a being contiguous to the substrate **10** as the low temperature grown layer whose crystal quality is low, it is possible to suppress the occurrence of a strain, and thereby suppress the occurrence of a pit formation on the upper surface of the AlN layer **11**a. On the other hand, by configuring the upper layer of the AlN layer **11**a as the high temperature grown layer whose crystal quality is high, it is possible to make high the crystal quality of the nitride semiconductor layer **12** to be epitaxially grown over the AlN layer **11**a.

The pits present on the upper surface of the AlN layer **11**a lead to the occurrence of a defect formation in the epitaxial crystal layers (the upper layer **11**b of the buffer layer **11** and the nitride semiconductor layer **12**) to be formed over the AlN layer **11**a.

Since GaN based crystals for constituting the upper layer **11**b of the buffer layer **11** and the nitride semiconductor layer **12** are grown in a lateral direction as well, a certain amount of defect formation can be repaired during the growth thereof (no defect can be inherited by the overlying layers). However, if the pit density of the upper surface of the AlN layer **11**a is high to some extent, the repair of defects resulting from the growth of the upper layer **11**b of the buffer layer **11** and the nitride semiconductor layer **12** cannot keep up with the formation of those defects and, as a result, those defects remain therein adjacent to the upper surface of that nitride semiconductor layer **12.** The amount of the defects contained in that nitride semiconductor layer **12** affects the breakdown voltage in a vertical direction of the semiconductor wafer **1.** Note that the breakdown voltage in the present embodiment refers to the voltage with the current density becoming **1** × **10⁻⁶** A/mm².

Further, even if the density of the defects in the nitride semiconductor layer **12** is constant in the semiconductor wafer **1,** as the chip area in a semiconductor device cut out from the semiconductor wafer **1** becomes large, the amount of the defects contained in the semiconductor device becomes large and, as a result, its adverse effect on the reliability of that semiconductor device becomes large. For this reason, when the semiconductor device designed to be high in its electric current rating and large in its chip area is cut out from the semiconductor wafer **1,** it is required to suppress the pit density of the upper surface of the AlN layer **11**a to be lower.

The pit density of the upper surface of the AlN layer **11**a is more than **0** but less than **2.4** × **10¹⁰** cm⁻². In this case, the densities of the defects in the upper layer **11**b of the buffer layer **11** and the nitride semiconductor layer **12** are kept low to such an extent that the breakdown voltage in the vertical direction of the semiconductor wafer **1** becomes more than approximately **650** V, thereby making it possible to cut out the semiconductor device designed to be **10** A in its electric current rating and for example, approximately **2** mm² in its chip area, from the semiconductor wafer **1.** In other words, even when the semiconductor wafer **1** contains the pits present on the upper surface of the AlN layer **11**a, as long as the pit density is less than **2.4** × **10¹⁰** cm⁻², no problem arises in applying that semiconductor wafer **1** to the semiconductor device designed to be **650** V and **10** A in its power rating.

Further, the pit density of the upper surface of the AlN layer **11**a is preferably not more than **5.5** × **10⁹** cm⁻². In this case, the densities of the defects in the upper layer **11**b of the buffer layer **11** and the nitride semiconductor layer **12** are kept low to such an extent that the breakdown voltage in the vertical direction of the semiconductor wafer **1** becomes more than approximately **650** V, thereby making it possible to cut out the semiconductor device designed to be **30** A in its electric current rating and for example, approximately **7** mm² in its chip area, from the semiconductor wafer **1.** In other words, even when the semiconductor wafer **1** contains the pits present on the upper surface of the AlN layer **11**a, as long as the pit density is not more than **5.5** × **10⁹** cm⁻², no problem arises in applying that semiconductor wafer **1** to the semiconductor device designed to be **650** V and **30** A in its power rating.

Further, the pit density of the upper surface of the AlN layer **11**a is preferably not more than **1.4** × **10⁹** cm⁻². In this case, the densities of the defects in the upper layer **11**b of the buffer layer **11** and the nitride semiconductor layer **12** are kept low to such an extent that the breakdown voltage in the vertical direction of the semiconductor wafer **1** becomes more than approximately **650** V, thereby making it possible to cut out the semiconductor device designed to be **70** A in its electric current rating and for example, approximately **16** mm² in its chip area, from the semiconductor wafer **1.** In other words, even when the semiconductor wafer **1** contains the pits present on the upper surface of the AlN layer **11**a, as long as the pit density is not more than **1.4** × **10⁹** cm⁻², no problem arises in applying that semiconductor wafer **1** to the semiconductor device designed to be **650** V and **70** A in its power rating.

Note that the properties of the semiconductor device described above are taken as the examples, and that the properties of the semiconductor device produced using the semiconductor wafer **1** are not limited to the foregoing. For example, by adding to the semiconductor wafer **1** a stack structure for enhancing the breakdown voltage in the vertical direction of the semiconductor wafer **1,** it is possible to apply the semiconductor wafer **1** to the semiconductor device designed to operate at a higher voltage.

In this manner, by using the pit density of the upper surface of the AlN layer **11**a for the quality criteria for the semiconductor wafer **1** to make a decision on the quality (the breakdown voltage in the vertical direction) of the semiconductor wafer **1,** and setting the quality decision criteria in accordance with the intended use of the semiconductor wafer **1,** it is possible to enhance the production yield for the semiconductor wafer **1** while ensuring the quality of the semiconductor wafer **1.**

The upper layer **11**b of the buffer layer **11** is made of a nitride semiconductor (a unary, binary or ternary compound semiconductor including a group III element and N (nitrogen) therein). For example, when the nitride semiconductor layer **12** is made of GaN, the upper layer **11**b is made of AlₓGa₁₋ₓN (**0** ≤ x ≤ **1**). The upper layer **11**b may have a multilayer structure such as a superlattice structure, or a graded composition structure, or the like.

The superlattice buffer structure is, for example, the structure in which AlₓGa₁₋ₓN films being large in its Al composition x (large in its lattice constant) and Al_{y}Ga_{1-y}N films being **0** or small in its Al composition y (small in its lattice constant) are alternately stacked therein. When the coefficient of thermal expansion of the substrate **10** is smaller than the coefficients of thermal expansion of the nitride semiconductors for constituting the buffer layer **11** and the nitride semiconductor layer **12,** during cooling those nitride semiconductors grown over the substrate **10** at the high growth temperatures, those nitride semiconductors are more greatly contracted than the substrate **10** and, as a result, those nitride semiconductors are subjected to a tensile stress. In this case, in order to allow a compressive stress caused in the buffer layer **11** to cancel out the tensile stress caused in those nitride semiconductors, it is preferable that the Al composition x of the AlₓGa₁₋ₓN films and the Al composition y of the Al_{y}Ga_{1-y}N films meet a condition **0** ≤ y < x ≤**1**, and that the AlₓGa₁₋ₓN films are thinner than the Al_{y}Ga_{1-y}N films. The graded composition buffer structure is, for example, the structure in which a plurality of AlₓGa₁₋ₓN films being different in the Al composition x are stacked therein with their respective Al compositions x becoming smaller from each underlying layer toward each overlying layer.

When employing the superlattice buffer structure therefor, it is possible to suppress the occurrence of such a warping as to protrude the semiconductor wafer **1** to the lower side (the substrate **10** side) of the semiconductor wafer **1,** which is caused by the difference between the coefficient of thermal expansion of the substrate **10** mainly composed of Si and the coefficient of thermal expansion of the nitride semiconductor layer **12.**

In the semiconductor wafer **1** warped to be protruded to the lower side thereof, the tensile stress is occurring in the nitride semiconductor layer **12** and, as a result, the nitride semiconductor layer **12** remains highly liable to a crack formation. Since the tensile stress in the nitride semiconductor layer **12** can be canceled out by the use of the superlattice buffer structure, it is possible to suppress the occurrence of the warping in the semiconductor wafer **1.**

When the coefficient of thermal expansion of the substrate **10** is smaller than the coefficients of thermal expansion of the nitride semiconductors for constituting the buffer layer **11** and the nitride semiconductor layer **12,** during cooling those nitride semiconductors grown over the substrate **10** at the high growth temperatures, those nitride semiconductors are more greatly contracted than the substrate **10** and, as a result, those nitride semiconductors are subjected to a tensile stress. In this case, in order to allow a compressive stress caused by the lattice mismatch between the buffer layer **11** and the nitride semiconductor layer **12** to cancel out the tensile stress caused in those nitride semiconductors, it is preferable that the *a* axis length (the length of the *a* axis of the unit cell) at the weighted mean of the composition ratios weighted by the amount of substance (mol) in the buffer layer **11** in a strain-free condition is smaller than the *a* axis length at the weighted mean of the composition ratios weighted by the amount of substance (mol) in the nitride semiconductor layer **12** in a strain-free condition.

The nitride semiconductor layer **12** is made of a nitride semiconductor, and may have a multilayer structure. In the example shown in **FIG. 1****,** the nitride semiconductor layer **12** is composed of a lower layer **12**a and an upper layer **12**b, which form a heterojunction between the lower layer **12**a and the upper layer **12**b. Typically, the lower layer **12**a is made of GaN while the upper layer **12**b is made of AlGaN. In this case, it is possible to produce a power device or a high frequency device, such as a HEMT (High Electron Mobility Transistor) or the like, which utilizes a two-dimensional electron gas generated adjacent to the upper surface of the lower layer **12**a of the nitride semiconductor layer **12** (the interface between the lower layer **12**a and the upper layer **12**b), from the semiconductor wafer **1.**

Even if the nitride semiconductors are not intentionally doped with impurities, a nitrogen deficiency occurs, or the oxygen and the silicon, which are residual impurities within the reactor, act as n-type dopants, and, as a result, the nitride semiconductors are low in electrical insulating performance. For this reason, in order to ensure a sufficient breakdown voltage of the semiconductor wafer **1,** the upper layer **11**b of the buffer layer **11** and the nitride semiconductor layer **12** include therein impurities for carrier compensation, such as impurities of C, Fe, Mn, Cr, Mg, Co, Ni, or the like. It is preferable that the concentrations of the impurities for carrier compensation to be included in the upper layer **11**b of the buffer layer **11** and the nitride semiconductor layer **12** are not less than **1** × **10¹⁸** cm⁻³ for the purpose of sufficiently compensating the carriers (electrons) produced by the nitrogen deficiency or the residual impurities within the reactor and thereby suppress the occurrence of a lowering in the breakdown voltage of the semiconductor wafer **1,** and are not more than **1** × **10²⁰** cm⁻³ because if the doping amounts thereof are too large, there is concern that the crystal qualities of the upper layer **11**b of the buffer layer **11** and the nitride semiconductor layer **12** may be lowered.

Note that the semiconductor device to which the semiconductor wafer **1** is applied is not limited to the one that utilizes a two-dimensional electron gas, but may be, for example, a light emitting device such as an LED (Light Emitting Diode) or the like.

### (Producing Method for the semiconductor wafer 1)

One example of a producing method for the semiconductor wafer **1** is shown below.

**FIGS. 2**A to **2C** are vertical cross-sectional views showing steps of producing the semiconductor wafer **1** according to the embodiment.

First, the substrate **10** is set within a glove box of a producing apparatus such as a MOCVD (metal organic chemical vapor deposition) apparatus or the like. The dew point within the glove box at this point of time is preferably less than **-30** degrees C, more preferably not more than **-40** degrees C, and still more preferably not more than **-70** degrees C. The dew point is the temperature at which dew condensation occurs, and the smaller the amount of moisture contained in the atmosphere, the lower the dew point.

By setting the dew point at less than **-30** degrees C, the pit density of the upper surface of the AlN layer **11**a is highly likely to become less than **2.4** × **10¹⁰** cm⁻². Further, by setting the dew point at not more than **-40** degrees C, the pit density of the upper surface of the AlN layer **11**a is highly likely to become not more than **5.5** × **10⁹** cm⁻², and by setting the dew point at not more than **-70** degrees C, the pit density of the upper surface of the AlN layer **11**a is highly likely to become not more than **1.4** × **10**⁹ cm⁻². The reason for the lower dew point making the pit density lower is because the pit formation mechanism is related to the oxygen impurities.

Note that the moisture within the glove box is typically removed by nitrogen purging or the like before setting the substrate **10,** but that, at this point of time, the oxygen is also removed at the same time as the moisture. For this reason, it is possible to indirectly know the amount of the oxygen by checking the dew point within the glove box when setting the substrate **10.** That is, the dew point can also be used as an index of the amount of the oxygen.

Next, for the purpose of removing a surface oxide film on the surface of the substrate **10** mainly composed of Si, the surface of the substrate **10** is subjected to H₂ annealing treatment. This H₂ annealing treatment is carried out under a temperature condition of not less than **900** degrees C, in order to reduce the surface oxide film on the surface of the substrate **10.** For example, the temperature of not less than **1000** degrees C and not more than **1060** degrees C is held for not shorter than **10** seconds.

When the AlN layer **11**a is formed over the substrate **10** with the surface oxide film remaining on the surface of the substrate **10,** a local growth failure occurs and, as a result, a large strain occurs at the boundary between the place with the local growth failure occurring thereon and the place with the AlN layer **11**a properly grown thereon, thus rendering the upper surface of the AlN layer **11**a liable to a pit formation. For this reason, in order to suppress the occurrence of the pit formation on the upper surface of the AlN layer **11**a, it is preferable to remove the surface oxide film on the surface of the substrate **10**.

Further, for the purpose of homogenizing the crystal qualities in substrate plane of the AlN layer **11**a and each layer to be formed over the AlN layer **11**a, a silicon nitride film may be formed over the surface of the substrate **10** by an ammonia treatment. Since the formation of that silicon nitride film over the surface of the substrate **10** allows an enhancement in the lattice matching properties between the AlN layer **11**a and the foundation underlying the AlN layer **11**a, it is possible to grow the AlN layer **11**a thereon at the high growth temperatures with no crack formation occurring in the AlN layer **11**a. The high growth temperature growth of the AlN layer **11**a allows an enhancement in the crystal quality of the AlN layer **11**a, and thereby allows an enhancement in the crystal quality of each layer grown over the AlN layer **11**a.

The silicon nitride film is formed thereover to have a thickness of not thinner than **0.5** nm and not thicker than **3** nm, typically a thickness of on the order of **1** nm. Here, if the silicon nitride film is formed with the surface oxide film remaining on the surface of the substrate **10,** a variation occurs in the thickness of the silicon nitride film and, as a result, a strain occurs in the AlN layer **11**a, thus rendering the upper surface of the AlN layer **11**a liable to a pit formation.

Note that even when no silicon nitride film is formed over the surface of the substrate **10** before the formation of the AlN layer **11**a, after the formation of the AlN layer **11**a, it is possible to partially form the silicon nitride film on the surface of the substrate **10** by diffusing nitrogen through the AlN layer **11**a formed over the substrate **10.** However, naturally, this partial silicon nitride film has no enhancing effect on the crystal quality of the AlN layer **11**a and the like.

In order to form the AlN layer **11**a over the surface of the substrate **10** with no crack formation occurring in the AlN layer **11**a without forming the silicon nitride film over the surface of the substrate **10,** for example, an AlN whose crystallinity is relatively poor may be first grown on the surface of the substrate **10** at a low growth temperature of on the order of **900** degrees C, and subsequently the AlN layer **11**a may be grown on that AlN with its relatively poor crystallinity at the high growth temperatures.

Next, as shown in **FIG. 2**A, an AlN is grown on the substrate **10** by the MOCVD or the like to form the AlN layer **11**a.

Alternatively, as described above, first, an AlN may be grown on the substrate **10** at a low growth temperature (e.g. **1000** to **1150** degrees C), and thereafter that AlN may be grown by elevating that growth temperature to a high growth temperature (e.g. **1100** to **1300** degrees C), so as to form the AlN layer **11**a including therein a low temperature grown layer, and a high temperature grown layer, which is formed over that low temperature grown layer.

Next, as shown in **FIG. 2B****,** the upper layer **11**b made of a nitride semiconductor is formed over the AlN layer **11**a by the MOCVD or the like. This results in the buffer layer **11.**

The buffer layer **11** is preferably formed thereover in such a manner that the (0001) crystal plane of the nitride semiconductor crystal for constituting that buffer layer **11** is substantially parallel to the substrate plane of the substrate **10.** By allowing the crystal plane of the nitride semiconductor crystal for constituting that buffer layer **11** to be aligned with the substrate plane of the substrate **10,** the inherent properties of the crystal can be exhibited. In forming the buffer layer **11,** the (**0001**) crystal plane of the nitride semiconductor crystal for constituting that buffer layer **11** can be made substantially parallel to the substrate plane of the substrate **10** by performing the crystal growth in such ranges of the ratio of the raw materials to be fed and the crystal growing temperature (for example, the value of the ratio of the amount of the group V raw material gas to be fed to the amount of the group III raw material gas to be fed is larger than **1** and the crystal growing temperature is less than **1400** degrees C) as to make the feeding partial pressures for the raw material gases of Ga and Al, that are elements in the group III in the periodic table, more than their partial pressures at the uppermost surface of the growing crystal on the substrate **10.**

Next, as shown in **FIG. 2**C, the nitride semiconductor layer **12** configured in such a manner as to include Ga therein is formed over the buffer layer **11** by the MOCVD or the like. This results in the semiconductor wafer **1.**

After that, the pit density of the upper surface of the AlN layer **11**a of the resulting semiconductor wafer **1** is measured by a cross section observation with a TEM (Transmission Electron Microscope) or the like, so that, by using that the pit density for the quality decision criteria for the resulting semiconductor wafer **1** in accordance with the intended use of the resulting semiconductor wafer **1,** it is possible to make an acceptance or rejection decision (as to whether or not the resulting semiconductor wafer **1** can be used), based on that quality decision criteria for the pit density in accordance with the intended use of the resulting semiconductor wafer **1.**

For example, when applying the resulting semiconductor wafer **1** to the semiconductor device designed to be **650** V and **10** A in its power rating, it is possible to make an acceptance decision when the pit density of the upper surface of the AlN layer **11**a is less than **2.4** × **10¹⁰** cm⁻². Further, when applying the resulting semiconductor wafer **1** to the semiconductor device designed to be **650** V and **30** A in its power rating, it is possible to make an acceptance decision when the pit density of the upper surface of the AlN layer **11**a is not more than **5.5** × **10**⁹ cm⁻². Further, when applying the resulting semiconductor wafer **1** to the semiconductor device designed to be **650** V and **70** A in its power rating, it is possible to make an acceptance decision when the pit density of the upper surface of the AlN layer **11**a is not more than **1.4** × **10⁹** cm⁻².

Note that the measurement and the acceptance or rejection decision to be made on the pit density of the upper surface of the AlN layer **11**a can be carried out at any timing after the formation of the same AlN layer **11**a. For example, they may be carried out immediately after the formation of the same AlN layer **11**a.

### (Advantageous effects of the embodiment)

According to the above-described embodiment, it is possible to provide the semiconductor wafer **1** which includes therein the nitride semiconductor layers over the Si substrate **10** and which has a structure designed to have a sufficient breakdown voltage for a specific use and be able to be produced at a high production yield, and it is possible to provide the production method for the same semiconductor wafer **1.**

With respect to the semiconductor wafer **1** according to the above-described embodiment, the relationships among the dew point of the atmosphere during the formation of the AlN layer **11**a, the pit density of the upper surface of the same AlN layer **11**a, and the breakdown voltage of the produced semiconductor wafer **1** were investigated. The details thereof will be described below.

In the present example, specimens A to G, which were the semiconductor wafers having the configurations shown in Table **1** below, were produced and evaluated. Note that it was confirmed that the breakdown voltages of the semiconductor wafers were not affected by the thickness, the diameter, the principal plane off angle, and the electrical conductivity type of the substrate **10.**

**[Table 1]**

| Name | | Structure / composition | | Thickness |
|---|---|---|---|---|
| Nitride semiconductor layer **12** | Upper layer **12**b | **Al_{0.25}Ga_{0.75}N** | | **25** nm |
| | Lower layer **12**a | GaN | | **1300** nm |
| Buffer layer 11 | Upper layer **11**b | Alternately stacked layers | **Al_{0.15}Ga_{0.85}N** | Total **3000** nm |
| | | | AlN | |
| | | **Al_{0.4}Ga_{0.6}N** | | **200** nm |
| | AlN layer **11**a | AlN | | **130** nm |
| Substrate **10** | | Diameter **150** mm (**6** inch), (**111**) p type Si substrate | | **675** µm |

The specimens A to G were each different in the dew point of the atmosphere during the formation of the AlN layer **11**a and, as a result, the specimens A to G were each different in the pit density of the upper surface of the AlN layer **11**a. Further, since the specimens A to G were each different in the pit density of the upper surface of the AlN layer **11**a, the specimens A to G were each different in the amount of the defects in the buffer layer **11** and the nitride semiconductor layer **12,** and different in the breakdown voltage in the vertical direction.

Table **2** below shows, for each of the specimens A to G, the dew point of the atmosphere during the formation of the AlN layer **11**a, the pit density of the upper surface of the AlN layer **11**a, and the breakdown voltage in the vertical direction. The breakdown voltages in the vertical direction of the specimens A to G were measured by applying a voltage between a metal electrode formed on the upper layer **12**b of the nitride semiconductor layer **12** and the substrate **10.**

**[Table 2]**

| | Dew point [°C] | Pit density [cm⁻²] | Breakdown voltage [V] | Decision *α* | Decision *β* | Decision *γ* |
|---|---|---|---|---|---|---|
| Specimen A | **-30** | **2.4** × **10¹⁰** | **140** | × | × | × |
| Specimen B | **-40** | **4.1** × **10⁹** | **770** | ○ | ○ | × |
| Specimen C | **-50** | **5.5** × **10⁹** | **760** | ○ | ○ | × |
| Specimen D | **-60** | **1.4** × **10⁹** | **780** | ○ | ○ | × |
| Specimen E | **-70** | **2.7** × **10⁹** | **760** | ○ | ○ | × |
| Specimen F | **-80** | Less than **1.4** × **10⁹** | **780** | ○ | ○ | ○ |
| Specimen G | **-90** | Less than **1.4** × **10⁹** | **780** | ○ | ○ | ○ |

The "Decision α" in Table **2** is an acceptance or rejection decision result when the specimens A to G were applied to the semiconductor device designed to be **650** V and **10** A in its power rating and **2** mm² in its chip area, and if each specimen was less than **2.4** × **10¹⁰** cm⁻² in the pit density of the upper surface of the AlN layer **11**a, then an acceptance decision denoted by "o" in Table **2** was made, or if each specimen was not less than **2.4** × **10¹⁰** cm⁻² in the pit density of the upper surface of the AlN layer **11**a, then a rejection decision denoted by "×" in Table **2 was** made.

The "Decision β" in Table **2** is an acceptance or rejection decision result when the specimens A to G were applied to the semiconductor device designed to be **650** V and **30** A in its power rating and **7** mm² in its chip area, and if each specimen was not more than **5.5** × **10⁹** cm⁻² in the pit density of the upper surface of the AlN layer **11**a, then an acceptance decision denoted by "o" in Table **2** was made, or if each specimen was more than **5.5** × **10⁹** cm⁻² in the pit density of the upper surface of the AlN layer **11**a, then a rejection decision denoted by "×" in Table **2** was made.

The "Decision γ" in Table **2** is an acceptance or rejection decision result when the specimens A to G were applied to the semiconductor device designed to be **650** V and **70** A in its power rating and **16** mm² in its chip area, and if each specimen was not more than **1.4** × **10⁹** cm⁻² in the pit density of the upper surface of the AlN layer **11**a, then an acceptance decision denoted by "o" in Table **2** was made, or if each specimen was more than **1.4** × **10⁹** cm⁻² in the pit density of the upper surface of the AlN layer **11**a, then a rejection decision denoted by "×" in Table **2** was made.

**FIG. 3**A is a graph showing a current-voltage characteristic of the specimen A. **FIG. 3**B is a TEM image showing a cross section in a perpendicular direction of the specimen A. The locations of the major pits observed in the TEM image of **FIG. 3**B are indicated by arrows.

**FIG. 4**Ais a graph showing a current-voltage characteristic of the specimen B. **FIG. 4**B is a TEM image showing a cross section in the perpendicular direction of the specimen B. The locations of the major pits observed in the TEM image of **FIG. 4**B are indicated by arrows.

**FIG. 5**A is a graph showing a current-voltage characteristic of the specimen C. **FIG. 5**B is a TEM image showing a cross section in the perpendicular direction of the specimen C. The locations of the major pits observed in the TEM image of **FIG. 5**B are indicated by arrows.

**FIG. 6**A is a graph showing a current-voltage characteristic of the specimen D. **FIG. 6**B is a TEM image showing a cross section in the perpendicular direction of the specimen D. The locations of the major pits observed in the TEM image of **FIG. 6**B are indicated by arrows.

**FIG. 7**A is a graph showing a current-voltage characteristic of the specimen E. **FIG. 7**B is a TEM image showing a cross section in the perpendicular direction of the specimen E. The locations of the major pits observed in the TEM image of **FIG. 7**B are indicated by arrows.

**FIG. 8**A is a graph showing a current-voltage characteristic of the specimen F. **FIG. 8**B is a TEM image showing a cross section in the perpendicular direction of the specimen F. In the TEM image of **FIG. 8**B, substantially no presence of the pits on the upper surface of the AlN layer **11**a can be observed.

**FIG. 9**A is a graph showing a current-voltage characteristic of the specimen G. **FIG. 9**B is a TEM image showing a cross section in the perpendicular direction of the specimen G. In the TEM image of **FIG. 9**B, substantially no presence of the pits on the upper surface of the AlN layer **11**a can be observed.

The densities of the pits on the upper surfaces of the respective AlN layers **11**a of the specimens A to G shown in Table **2** were obtained from the numbers of pits measured within the predetermined ranges of the fields of view in the cross-sectional TEM images shown in **FIGS. 3** to **9** (the widths in the lateral direction in the cross-sectional TEM images shown in **FIGS. 3** to **9**) and the predetermined ranges of the depths in the cross-sectional TEM images shown in **FIGS. 3** to **9** (the widths in the direction perpendicular to the page in the cross-sectional TEM images shown in **FIGS. 3** to **9**). Further, the breakdown voltages in the vertical direction of the specimens A to G shown in Table **2** were obtained from the current-voltage characteristics shown in **FIGS. 3** to **9****.** Table **3** below shows the fields of view and the depths in the measurement of the numbers of pits of the specimens A to G, and the numbers of pits measured within the ranges defined by those fields of view and those depths.

**[Table 3]**

| | Field of view [nm] | Depth [cm⁻²] | Number of pits |
|---|---|---|---|
| Specimen A | **730** | **100** | **14** |
| Specimen B | **1170** | **50** | **3** |
| Specimen C | **1170** | **50** | **4** |
| Specimen D | **1170** | **50** | **1** |
| Specimen E | **1170** | **50** | **2** |
| Specimen F | **1170** | **50** | **0** |
| Specimen G | **1170** | **50** | **0** |

**FIG. 10** is a graph showing the relationships between the dew points during the formation of the respective AlN layers **11**a and the densities of the pits on the upper surfaces of the respective AlN layers **11**a, which were obtained from the results of the measurement of the specimens A to G.

Although the embodiments of the present invention and the examples thereof have been described above, the present invention is not limited to the above described embodiments and the above described examples, but the present invention can be variously modified and implemented without departing from the spirit thereof.

Further, the above described embodiments and the above described examples are not to be construed as limiting the inventions according to the appended claims. Further, it should be noted that not all the combinations of the features described in the embodiments and the examples are indispensable to the means for solving the problem of the invention.

The present invention provides the semiconductor wafer, which includes therein the nitride semiconductor layers over the Si substrate, and which has a structure designed to have a sufficient breakdown voltage for a specific use and be able to be produced at a high production yield.

Although the invention has been described with respect to the specific embodiments for complete and clear disclosure, the appended claims are not to be thus limited but are to be construed as embodying all modifications and alternative constructions that may occur to one skilled in the art which fairly fall within the basic teaching herein set forth.

### [Descriptions of the reference characters]

**1** Semiconductor wafer
**10** Substrate
**11** Buffer layer
**11**a AlN layer
**11**b Upper layer
**12** Nitride semiconductor layer
**12**a Lower layer
**12**b Upper layer

## Claims

1. A semiconductor wafer, comprising:
a substrate mainly composed of Si;
a buffer layer formed over the substrate and comprises an AlN layer as a lowermost layer; and
a nitride semiconductor layer formed over the buffer layer and includes Ga,
wherein the semiconductor wafer is configured in such a manner that a pit density of an upper surface of the AlN layer is more than **0** but less than **2.4** × **10¹⁰** cm⁻².

2. The semiconductor wafer according to claim **1,** wherein the pit density of the upper surface of the AlN layer is not more than **5.5** × **10⁹** cm⁻².

3. The semiconductor wafer according to claim **2,** wherein the pit density of the upper surface of the AlN layer is not more than **1.4** × **10⁹** cm⁻².
